(19) Europäisches Patentamt
European Patent Office
Office européen des brevets

(11) **EP 3 987 655 B1**

(12) **FASCICULE DE BREVET EUROPEEN**

(45) Date de publication et mention
de la délivrance du brevet:
**26.07.2023 Bulletin 2023/30**

(21) Numéro de dépôt: **20743195.8**

(22) Date de dépôt: **09.06.2020**

(51) Classification Internationale des Brevets (IPC):
***H02S 50/10*** *(2014.01)*

(52) Classification Coopérative des Brevets (CPC):
**H02S 50/10;** Y02E 10/50

(86) Numéro de dépôt international:
**PCT/FR2020/050978**

(87) Numéro de publication internationale:
**WO 2020/254742 (24.12.2020 Gazette 2020/52)**

(54) **PROCEDE DE CARACTERISATION ELECTRIQUE D'UNE CELLULE PHOTOVOLTAIQUE DECOUPEE**

VERFAHREN ZUR ELEKTRISCHEN CHARAKTERISIERUNG EINER GESCHNITTENEN PHOTOVOLTAISCHEN ZELLE

METHOD FOR ELECTRICALLY CHARACTERISING A CUT PHOTOVOLTAIC CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.06.2019 FR 1906688**

(43) Date de publication de la demande:
**27.04.2022 Bulletin 2022/17**

(73) Titulaire: **Commissariat à l'énergie atomique et aux énergies alternatives**
**75015 Paris (FR)**

(72) Inventeurs:
• **EYMARD, Julien**
**38054 GRENOBLE CEDEX 09 (FR)**
• **GERENTON, Felix**
**38054 GRENOBLE CEDEX 09 (FR)**
• **HARRISON, Samuel**
**38054 GRENOBLE Cedex 09 (FR)**
• **MUNOZ, Maria-Delfina**
**38054 GRENOBLE CEDEX 09 (FR)**

(74) Mandataire: **Brevalex**
**Tour Trinity**
**1 B Place de la Défense**
**92400 Courbevoie (FR)**

(56) Documents cités:
**WO-A1-2013/179898     US-A1- 2011 208 372**

EP 3 987 655 B1

## Description

### DOMAINE TECHNIQUE ET ART ANTÉRIEUR

L'invention concerne le domaine de la caractérisation électrique et de la mesure des performances électriques de sous-cellules photovoltaïques obtenues en découpant une cellule photovoltaïque. Le document WO2013/179898A décrit un procédé de caractérisation électrique d'au moins une cellule photovoltaïque.

L'utilisation de sous-cellules photovoltaïques, c'est-à-dire de cellules photovoltaïques découpées, permet d'améliorer les performances électriques des modules photovoltaïques qui comportent des sous-cellules photovoltaïques par rapport aux modules photovoltaïques réalisés avec des cellules photovoltaïques entières, c'est-à-dire non découpées. En effet, la découpe d'une cellule photovoltaïque en plusieurs sous-cellules permet, pour une même surface de réception lumineuse, de réduire le courant généré par les sous-cellules par rapport à celui généré par une même cellule non découpée. Ce courant plus faible engendre des pertes résistives plus faibles dans les rubans d'interconnexion utilisés dans les modules photovoltaïques, et permet donc d'améliorer les performances de conversion électrique des modules photovoltaïques.

Par contre, la découpe de cellules photovoltaïques pour réaliser des sous-cellules forme, au niveau des lignes de découpe, des bords non protégés par les couches de passivation présentes sur la cellule photovoltaïque initiale. La découpe peut également détériorer le semi-conducteur se trouvant à proximité des lignes de découpe et/ou introduire des impuretés dans le semi-conducteur (comme c'est par exemple le cas lors d'une découpe par laser). Ces défauts induisent des pertes localisées dans la durée de vie des porteurs de charge minoritaires générés dans ces zones de découpe, ce qui se traduit par des pertes de courant et de tension à proximité du point de fonctionnement des sous-cellules. Cet effet est particulièrement visible lors de la découpe d'une cellule à hétérojonction (HET) qui possède par nature très peu de défauts de passivation de surface et dans laquelle la création de quelques défauts localisés suffit à réduire les performances électriques globales de la cellule de manière significative.

Usuellement, les cellules photovoltaïques sont caractérisées électriquement en fin de ligne de production afin de quantifier leurs performances et de les trier. L'étape de tri permet de créer des classes de cellules ayant des performances électriques similaires. Ces classes permettent ensuite de créer des modules photovoltaïques ayant des performances similaires ou proches, et d'éviter des pertes de puissance au niveau des modules photovoltaïques qui seraient dues à des différences importantes entre les caractéristiques électriques des cellules photovoltaïques utilisées dans un même module. En effet, si les cellules d'un même module ont des performances éloignées, les cellules ayant de mauvaises performances individuelles peuvent dégrader le fonctionnement des cellules ayant de bonnes performances. Ce type de problème est évité quand toutes les cellules d'un module photovoltaïques ont des performances électriques identiques ou proches.

Cela s'applique également pour les modules photovoltaïques réalisés à partir de sous-cellules photovoltaïques. Les sous-cellules photovoltaïques sont caractérisées individuellement pour former des classes de sous-cellules et réaliser des modules photovoltaïques avec des sous-cellules de même classe.

Des cellules photovoltaïques ayant les mêmes performances électriques théoriques n'ont pas, en réalité, une répartition spatiale homogène. Il existe donc potentiellement une disparité cachée entre des cellules photovoltaïques d'une même classe. Du fait que chaque cellule photovoltaïque n'est pas parfaitement homogène, l'étape de découpe engendre une disparité additionnelle dans les caractéristiques électriques des sous-cellules obtenues, du fait que des parties d'une même cellule qui ont des performances différentes sont séparées physiquement pour former des sous-cellules distinctes. Cette disparité additionnelle s'ajoute donc à la disparité déjà existante entre différentes cellules entières, non découpées.

Mesurer individuellement les caractéristiques électriques des sous-cellules photovoltaïques permet de quantifier les performances électriques des sous-cellules individuellement et de les trier. En revanche, la mesure individuelle des caractéristiques électriques des sous-cellules ne permet pas de quantifier et différencier les deux effets liés à la découpe des cellules, c'est-à-dire la disparité additionnelle liée à l'inhomogénéité des performances électriques au sein de chaque cellule photovoltaïque et les pertes dues à la dégradation des cellules engendrée par le procédé de découpe des cellules.

### EXPOSÉ DE L'INVENTION

Un but de la présente invention est de proposer un procédé permettant de quantifier précisément l'impact d'une découpe sur les performances électriques d'une cellule photovoltaïque, c'est-à-dire quantifier la disparité additionnelle liée à l'inhomogénéité des performances électriques au sein de la cellule photovoltaïque et mesurer les pertes de performance dues à la dégradation de la cellule photovoltaïque engendrée par le procédé de découpe, et permettant également de différencier correctement ces deux effets engendrés par la découpe de la cellule photovoltaïque en plusieurs sous-cellules photovoltaïques.

Pour cela, il est proposé un procédé de caractérisation électrique d'au moins une cellule photovoltaïque découpée, comportant :

 a) mesure de la caractéristique I-V de la cellule photovoltaïque non découpée ;
 b) découpe de la cellule photovoltaïque en plusieurs sous-cellules photovoltaïques ;

c) mesure de la caractéristique I-V de chacune des sous-cellules photovoltaïques non reliées électriquement aux autres sous-cellules photovoltaïques ;

d) mesure de la caractéristique I-V d'un ensemble comprenant toutes les sous-cellules photovoltaïques reliées électriquement entre elles en parallèle ;

e) détermination, à partir des caractéristiques I-V mesurées, d'au moins un paramètre de performance électrique de la cellule photovoltaïque non découpée, d'au moins un paramètre de performance électrique de chacune des sous-cellules photovoltaïques et d'au moins un paramètre de performance électrique de l'ensemble comprenant toutes les sous-cellules photovoltaïques reliées électriquement entre elles en parallèle ;

f) calcul, pour chacune des sous-cellules photovoltaïques, de la différence entre la valeur du paramètre de performance électrique de la sous-cellule photovoltaïque et la valeur du paramètre de performance électrique de la cellule photovoltaïque non découpée ;

g) calcul de la différence entre la valeur du paramètre de performance électrique de l'ensemble comprenant toutes les sous-cellules photovoltaïques reliées électriquement entre elles en parallèle et la valeur du paramètre de performance électrique de la cellule photovoltaïque non découpée.

L'étape a) permet de quantifier les performances initiales de la cellule photovoltaïque entière, avant la découpe. L'étape c) permet de quantifier individuellement les performances électriques des sous-cellules découpées. A l'étape d), les performances électriques de l'ensemble des sous-cellules reconnectées sont quantifiées.

Les caractéristiques I-V sont mesurées aux bornes de sortie de la cellule photovoltaïque non découpée, de chacune des sous-cellules photovoltaïques et de l'ensemble comprenant toutes les sous-cellules photovoltaïques reliées électriquement entre elles en parallèle. Lors d'une mesure de caractéristique I-V, le courant est mesuré aux bornes de sortie et on fait varier la charge aux bornes de l'élément dont la caractéristique I-V est mesurée.

La mesure réalisée à l'étape d) permet de mesurer la caractéristique I-V de l'ensemble formé de toutes les sous-cellules photovoltaïques reliées électriquement entre elles en parallèle, dans lequel les sous-cellules photovoltaïques se limitent de la même manière que lorsque la cellule photovoltaïque est non découpée. Cette mesure permet donc d'accéder directement aux pertes de performance dues à la dégradation de la cellule photovoltaïque engendrée par le procédé de découpe en réalisant le calcul de l'étape g).

La mesure réalisée à l'étape c) permet de faire ressortir la disparité des performances électriques des sous-cellules et d'évaluer ensuite leurs performances électriques individuelles, qui ne sont pas accessibles si seule l'étape d) était mise en oeuvre. Le calcul réalisé à l'étape f) permet de quantifier précisément la disparité additionnelle liée à l'inhomogénéité des performances électriques au sein de la cellule photovoltaïque.

La mesure des pertes de performance dues à la dégradation de la cellule engendrée par le procédé de découpe est directement représentative de la qualité du procédé de découpe mise en oeuvre. Ce procédé peut donc être mis en oeuvre pour assurer un suivi continu de la qualité de découpe sur une ligne de production incluant une découpe de cellules photovoltaïques en sous-cellules photovoltaïques, et cela sans réduire le débit de la ligne de production.

Ce procédé a également pour avantage de pouvoir être mis en oeuvre en minimisant le nombre d'équipements électroniques nécessaires aux mesures, et en utilisant des équipements de mesure de caractéristique I-V existants avec un minimum de modifications.

A l'étape f), le paramètre de performance électrique de chaque sous-cellule photovoltaïque et le paramètre de performance électrique de la cellule photovoltaïque non découpée utilisés pour le calcul sont de même nature (courant, tension, puissance, etc.).

A l'étape g), le paramètre de performance électrique de l'ensemble comprenant toutes les sous-cellules photovoltaïques reliées électriquement entre elles en parallèle et le paramètre de performance électrique de la cellule photovoltaïque non découpée utilisés pour le calcul sont de même nature.

Aux étapes f) et g), ce sont les valeurs absolues des différences calculées qui sont prises en compte pour quantifier l'impact de la découpe sur les performances électriques de la cellule.

Les paramètres de performance électrique utilisés pour le calcul de l'étape f) peuvent être de même nature que ceux utilisés pour le calcul de l'étape g).

De manière avantageuse, les paramètres de performance électrique utilisés pour les calculs des étapes f) et g) peuvent correspondre à des tensions de circuit ouvert. Choisir la tension de circuit ouvert en tant que paramètre de performance électrique permet d'avoir un paramètre très représentatif des pertes de performance engendrées par le procédé de découpe et de la disparité additionnelle liée à l'inhomogénéité des performances électriques au sein de la cellule photovoltaïque.

De manière générale, les paramètres de performance électrique peuvent correspondre à un ou plusieurs des paramètres suivants : le courant de court-circuit $I_{SC}$ ou la densité de courant de court-circuit $J_{SC}$, la tension en circuit ouvert $V_{OC}$, le facteur de forme FF, le courant maximal Imax, la tension maximale Vmax, la puissance maximale Pmax, le rendement de conversion $\eta$, le rendement de conversion bifacial (dans lequel les puissances générées sur les deux faces sont prises en compte). Il est également possible de prendre en compte des paramètres de performance électrique reflétant l'évolution des performances sur les deux faces avant et après la découpe de la cellule photovoltaïque.

Les étapes a), c) et d) peuvent être mises en oeuvre avec au moins :

- un dispositif de mesure de tension et de courant ;
- des éléments de contact disposés contre des métallisations présentes au niveau des faces avant et arrière de la cellule photovoltaïque, chacun des éléments de contact comportant plusieurs parties isolées électriquement les unes des autres et configurées pour être chacune reliée au dispositif de mesure de tension et de courant.

Ainsi, les mêmes éléments de contact peuvent être utilisés pour toutes les mesures de caractéristiques I-V du procédé.

Lors des étapes a) et d), des interrupteurs peuvent être configurés pour relier électriquement, pour au moins un des éléments de contact, les parties dudit élément de contact, et lors de l'étape c), les interrupteurs peuvent être configurés pour isoler électriquement les parties dudit élément de contact.

Les interrupteurs peuvent correspondre à des transistors de puissance et/ou être disposés au sein des éléments de contact.

Les éléments de contact peuvent comporter des peignes chacun muni de plusieurs groupes de pointes avec, dans chaque groupe des pointes, des pointes destinées à une mesure de tension et des pointes destinées à une mesure de courant, et chaque partie d'un des éléments de contact peut comprendre au moins un des groupes de pointes.

Lors des étapes a), c) et d), les pointes des peignes peuvent être mises en contact avec des métallisations de type bus barres, également appelées busbars ou barres collectrices, présentes au niveau de la face avant et/ou de la face arrière de la cellule photovoltaïque.

En variante, les éléments de contact peuvent comporter des fils qui sont mis en contact avec les métallisations présentes au moins au niveau de la face avant de la cellule photovoltaïque. De tels éléments de contact sont adaptés pour des cellules photovoltaïques qui ne comportent pas de bus barres.

Les éléments de contact peuvent comporter en outre au moins un élément électriquement conducteur mis en contact avec une métallisation présente sur une face arrière de la cellule photovoltaïque, l'élément électriquement conducteur pouvant comporter, lors de l'étape c), plusieurs parties isolées électriquement les unes des autres.

Les étapes a), c) et d) peuvent être mises en oeuvre en illuminant la cellule photovoltaïque avec un même spectre lumineux, avec une même puissance lumineuse et à une même température.

L'étape b) peut comporter la mise en oeuvre d'une découpe laser et/ou d'un clivage mécanique et/ou d'une découpe avec une scie ou un fil diamanté et/ou d'une découpe par jet d'eau.

De manière avantageuse, lors de l'étape c), les caractéristiques I-V des sous-cellules photovoltaïques peuvent être mesurées simultanément, en parallèle. Lorsque ce procédé est mis en oeuvre sur une ligne de production de modules photovoltaïques, cela permet de ne pas diminuer le débit de la ligne de production. Plusieurs dispositifs de mesure peuvent dans ce cas être nécessaires pour la mise en oeuvre de cette étape c). En variante, il est possible de caractériser successivement chacune des sous-cellules, c'est-à-dire mesurer successivement les caractéristiques I-V des sous-cellules photovoltaïques les unes après les autres.

L'équipement de mesure peut être le même pour chaque mesure réalisée, ou il est possible d'avoir plusieurs équipements de mesure chacun dédié à une ou plusieurs des étapes de mesure.

En variante, lors de l'étape c), les caractéristiques I-V des sous-cellules photovoltaïques peuvent être mesurées successivement par un même dispositif de mesure de tension et de courant, les résultats de mesure étant multiplexés temporellement en sortie du dispositif de mesure.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente, sous la forme d'un organigramme, un procédé de caractérisation électrique d'une cellule photovoltaïque découpée, objet de la présente invention ;
- les figures 2 à 7 représentent schématiquement la cellule photovoltaïque lors de la mise en oeuvre de différentes étapes du procédé de caractérisation électrique de la cellule photovoltaïque, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

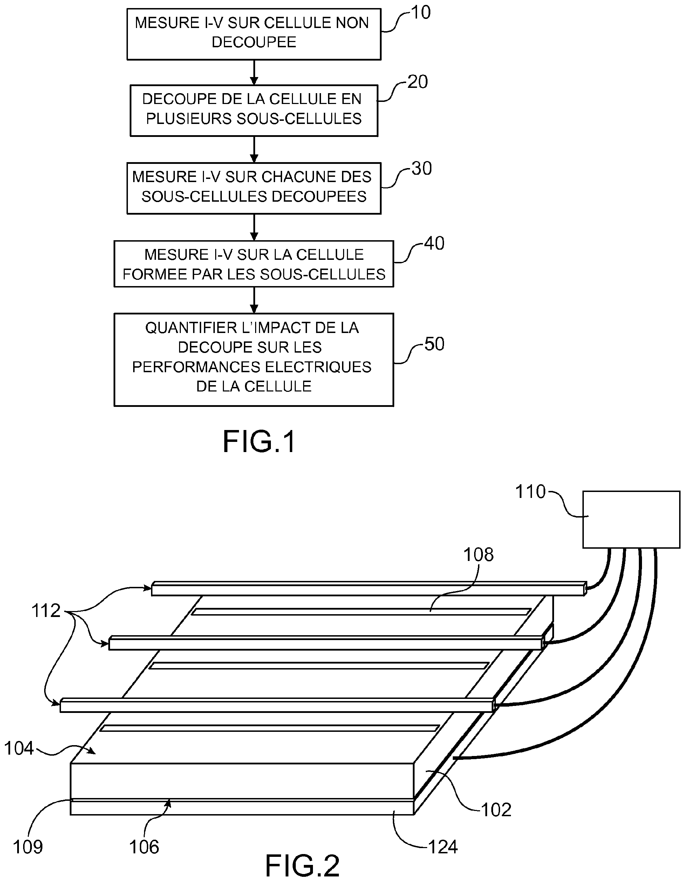

Un procédé de caractérisation électrique d'une cellule photovoltaïque 102 découpée, permettant de quantifier l'impact de la découpe sur les performances électriques de la cellule photovoltaïque 102, est décrit ci-dessous en lien avec les figures 1 à 7. La figure 1 représente, sous la forme d'un organigramme, les étapes du procédé qui sont mises en oeuvre.

La cellule 102 (visible sur la figure 2) correspond par exemple à une cellule HET. En variante, la cellule 102 peut être de type à pérovskite, tandem HET sur pérovskite, AI-BSF (Aluminium Back Surface Field), PERC (Passivated Emitter and Rear Contact), PERT (Passivated Emitter and Rear Totally diffused), à homojonction, à matériau III-V, à contacts passivés, ou tout autre type de cellule photovoltaïque qui soit compatible avec une découpe en plusieurs sous-cellules. La cellule 102 peut avoir n'importe quelles dimensions et n'importe quelle forme, par exemple carrée ou pseudo-carrée.

La cellule 102 comporte une face avant 104 et une face arrière 106. La cellule 102 comporte des métallisations présentes sur chacune de ces faces 104, 106. Dans l'exemple représenté sur la figure 2, les métallisations présentes sur la face avant 104 de la cellule 102 correspondent à des doigts de collecte (non représentés sur la figure 2) sur lesquels sont disposés des bus barres 108 qui permettent de collecter le courant électrique généré par la cellule 102 et qui circulent dans les doigts de collecte.

Sur l'exemple visible sur la figure 2, la cellule 102 comporte trois bus barres 108 disposés sur la face avant 104. En variante, la cellule 102 peut comporter un nombre différent de bus barres 108 présents sur la face avant 104.

La cellule 102 comporte également, au niveau de sa face arrière 106, une métallisation 109 recouvrant par exemple toute la face arrière 106.

Selon une variante, la cellule 102 peut comporter, au niveau de sa face arrière 106 et à la place de cette métallisation 109, des doigts de collecte et des bus barres, par exemple similaires aux bus barres 108 présents sur la face avant 104.

Selon une autre variante, la cellule 102 peut comporter, au niveau de la face avant 104 et/ou de la face arrière 106, des métallisations qui soient différentes de celles décrites précédemment.

Lors d'une première étape 10 du procédé, une mesure de la caractéristique I-V de la cellule 102 non découpée est mise en oeuvre. Cette mesure est par exemple réalisée dans des conditions de test standards, ou STC (Standard Test Conditions), c'est-à-dire en illuminant la cellule 102 avec un simulateur solaire émettant une lumière possédant un spectre normalisé tel qu'un spectre solaire AM1.5 de 1000W/m$^2$, à une température de 25°C.

Cette mesure de caractéristique I-V est mise en oeuvre en utilisant :

- un dispositif de mesure de tension et de courant 110,
- des éléments de contact 112, par exemple de type peignes ou grilles, et par exemple munis de groupes de pointes permettant de réaliser des mesures de type 4 pointes le long de chacun des bus barres 108, et
- un élément de contact 124 disposé contre la métallisation arrière 109.

Les éléments de contact 112 et 124 sont reliés électriquement à des entrées du dispositif de mesure de tension et de courant 110.

Lors de la mesure de la caractéristique I-V de la cellule 102, les éléments de contact 112 sont mis en contact avec les bus barres 108 et l'élément de contact 124 est mis en contact avec la métallisation 109.

Lors de cette mesure de la caractéristique I-V de la cellule 102, le courant électrique généré par la cellule 102 est mesuré pour différentes valeurs de tension aux bornes de la cellule 102. La caractéristique I-V mesurée correspond à une courbe représentant le courant délivré par la cellule 102 en fonction de la valeur de la tension aux bornes de la cellule 102.

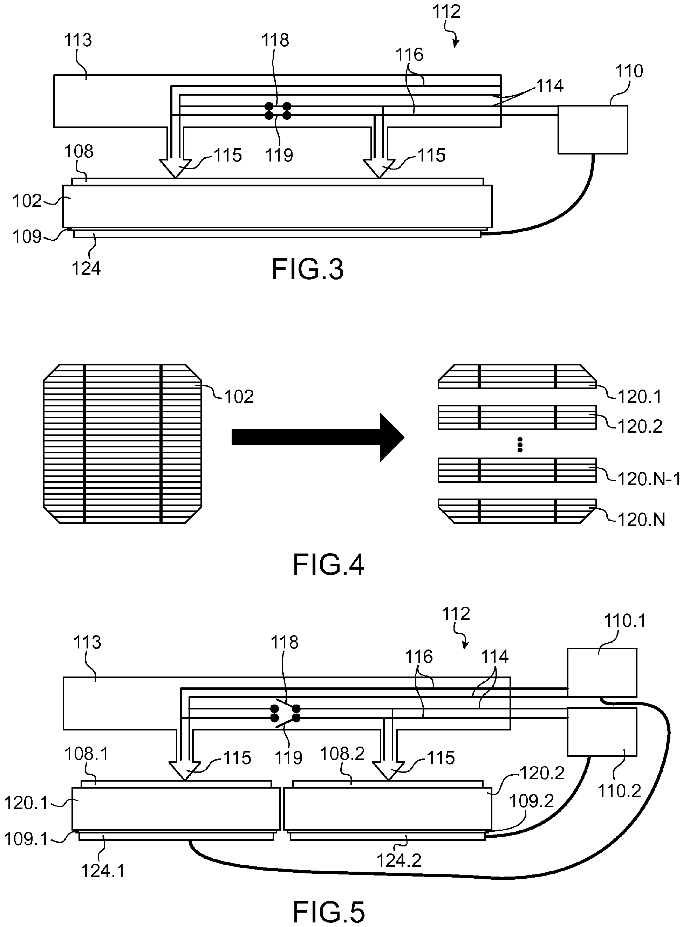

La figure 3 représente une vue schématique en coupe de la cellule 102 et d'un exemple de réalisation d'un des éléments de contact 112 lorsque celui-ci est en contact avec un des bus barres 108 présents en face avant de la cellule 102, lors de la mesure de la caractéristique I-V de la cellule 102.

Dans l'exemple décrit ici, les éléments de contact 112 correspondent à des peignes conducteurs 113 munis de groupes de pointes de contact 115 mises physiquement en contact avec les bus barres 108 de la cellule 102 lors de la mesure de la caractéristique I-V de la cellule 102. Au sein d'un même groupe de pointes de contact 115, le fil auquel les pointes 115 des éléments de contact 112 utilisées pour la mesure de courant sont reliées est isolé électriquement du fil auquel les pointes 115 des éléments de contact 112 utilisées pour la mesure de tension. Sur la figure 3, deux flèches représentent deux groupes de pointes de contact 115.

Au sein de chaque élément de contact 112, les pointes 115 utilisées pour les mesures de tension sont reliées électriquement entre elles par des premières liaisons électriques 114 servant également à relier les pointes de mesure de tension au dispositif de mesure de tension et de courant 110. Les pointes 115 utilisées pour les mesures de courant sont reliées électriquement entre elles par des deuxièmes liaisons électriques 116 servant également à relier les pointes de mesure de courant au dispositif de mesure de tension et de courant 110. Les premières liaisons électriques 114 sont distinctes des deuxièmes liaisons électriques 116, et les premières liaisons électriques 114 ne sont pas reliées électriquement aux deuxièmes liaisons électriques 116.

De manière avantageuse, pour que les éléments de contact 112 puissent servir à la fois à la mesure de la caractéristique I-V de la cellule 102 non découpée et aux mesures des caractéristiques I-V de chacune des sous-cellules qui seront obtenues par la suite en découpant la cellule 102, chacun des éléments de contact 112 comporte plusieurs parties isolées électriquement les unes des autres et configurées pour être chacune reliée électriquement au dispositif de mesure de tension et de courant 110.

Dans chaque élément de contact 112, pour pouvoir relier électriquement ou isoler électriquement ces parties entre elles, les premières liaisons électriques 114 de chaque élément de contact 112 incluent un ou plusieurs interrupteurs 118 qui permettent, à l'état fermé, de relier électriquement entre elles toutes les pointes 115 de l'élément de contact 112 servant à la mesure de tension. De même, les deuxièmes liaisons électriques 116 de chaque élément de contact 112 incluent un ou plusieurs interrupteurs 119 qui permettent, à l'état fermé, de relier électriquement entre elles toutes les pointes 115 de l'élément de contact 112 servant à la mesure de courant. Les interrupteurs 118, 119 correspondent par exemple à des transistors de puissance.

Le nombre d'interrupteurs 118 et 119 présents dans chaque élément de contact 112 est choisi notamment en fonction du nombre de sous-cellules destinées à être caractérisées indépendamment au cours des prochaines étapes du procédé.

En variante, il est possible que les interrupteurs 118, 119 ne soient pas inclus dans les éléments de contact 112, mais soient disposés en dehors des éléments de contact 112, par exemple au sein d'un dispositif de connexion extérieur aux éléments de contact 112. Dans ce cas, les premières et deuxièmes liaisons électriques 114, 116 ne sont pas directement reliées au dispositif de mesure 110, mais sont reliées au dispositif de connexion, lui-même relié au dispositif de mesure 110.

Du fait que, lors de cette première étape 10, la caractéristique I-V mesurée est celle de la cellule 102 entière, c'est-à-dire non découpée, les interrupteurs 118 et 119 sont à l'état fermé afin que, dans chacun des éléments de contact 112, toutes les pointes 115 de mesure de tension soient reliées électriquement entre elles pour ne former qu'un seul circuit de mesure de tension mesurant la tension obtenue sur toute la longueur de chaque bus barre 108 et que toutes les pointes 115 de mesure de courant soient reliées électriquement de sorte à ne former qu'un seul circuit de mesure de courant mesurant le courant délivré sur toute la longueur de chaque bus barre 108.

Lors d'une deuxième étape 20 du procédé, la cellule 102 est découpée en plusieurs sous-cellules 120. La figure 4 représente schématiquement plusieurs sous-cellules 120.1 - 120.N obtenues suite à la découpe de la cellule 102. De préférence, les sous-cellules 120 ont des dimensions et des formes identiques ou proches les unes par rapport aux autres.

La ou les techniques de découpe mises en oeuvre peuvent être de n'importe quel type et sont choisies notamment en fonction des caractéristiques (matériaux, épaisseur, etc.) de la cellule 102 : découpe laser sur toute l'épaisseur de la cellule 102, clivage mécanique, découpe laser suivie d'un clivage mécanique, sciage par exemple avec une scie à disque diamanté, découpe par fil diamanté, découpe laser suivie d'une découpe par jet d'eau, etc.

La cellule 102 est découpée pour former N sous-cellules 120, avec N nombre entier supérieur ou égal à 2.

Cette découpe de la cellule 102 scinde en plusieurs parties chacun des bus barres 108 ainsi que la métallisation 124.

Au cours d'une troisième étape 30, une mesure d'une caractéristique I-V de chacune des sous-cellules 120 est mise en oeuvre. La mesure de la caractéristique I-V de chaque sous-cellule 120 est mise en oeuvre dans les mêmes conditions d'illumination et de mesure que celles avec lesquelles la précédente mesure de la caractéristique I-V de la cellule 102 non découpée est mise en oeuvre.

Dans le mode de réalisation particulier décrit ici, les éléments de contact 112 sont utilisés pour mesurer la caractéristique I-V de la cellule 102 non découpée, et également pour mesurer les caractéristiques I-V des sous-cellules 120. Préalablement aux mesures des caractéristiques I-V des sous-cellules 120, les sous-cellules 120 sont donc réassemblées, c'est-à-dire disposées côte à côte, pour reconstituer un ensemble ayant physiquement une géométrie identique ou proche de celle de la cellule 102.

Les interrupteurs 118, 119 sont mis à l'état ouvert afin que, dans chacun des éléments de contact 112, les liaisons électriques 114, 116 et les pointes 115 de mesure de tension et de mesure de courant forment plusieurs circuits de mesure indépendants, isolés électriquement les uns des autres, afin de mesurer, de manière indépendante, les caractéristiques I-V de chacune des sous-cellules 120. Sur l'exemple représenté sur la figure 5 qui correspond au cas où la cellule 102 est découpée pour former deux sous-cellules, ou demi-cellules, 120.1, 120.2, l'ouverture des interrupteurs 118, 119 permet aux premières liaisons électriques 114 et aux groupes de pointes 115 de mesure de tension de former deux circuits de mesure de tension indépendants, isolés électriquement l'un de l'autre et comportant des pointes différentes l'un par rapport à l'autre. L'état ouvert des interrupteurs 118, 119 permet également aux deuxièmes liaisons électriques 116 et aux groupes de pointes 115 de mesure de courant de former deux circuits de mesure de courant indépendants, isolés électriquement l'un de l'autre et comportant des pointes différentes l'un par rapport à l'autre. Les pointes d'un premier des deux circuits de mesure de tension et d'un premier des deux circuits de mesure de courant sont en contact avec des premières parties 108.1 des bus barres 108 localisées sur la première sous-cellule 120.1, et les pointes d'un deuxième des deux circuits de mesure de tension et d'un deuxième des deux circuits de mesure de courant sont en contact avec des deuxièmes parties 108.2 des bus barres 108 localisées sur la deuxième sous-cellule 120.2.

De même, avec la découpe de la cellule 102, l'élément de contact 124 utilisé pour contacter les parties de la métallisation 109 présentes en face arrière 106 des sous-cellules 120 est scindé en plusieurs parties distinctes et isolées électriquement les unes des autres afin de réaliser les mesures des caractéristiques I-V des sous-cellules 120 indépendamment les unes des autres. Sur l'exemple représenté sur la figure 5, l'élément de contact 124 est scindé en deux parties 124.1, 124.2 isolées électriquement l'une de l'autre, chacune étant en contact avec une des parties 109.1, 109.2 de la métallisation 109.

Les mesures des caractéristiques I-V des sous-cellules 120 peuvent être réalisées simultanément, en parallèle, en utilisant plusieurs dispositifs de mesure 110. Sur l'exemple de la figure 5, deux dispositifs de mesure 110.1, 110.2 sont présents, chacun relié à l'un des deux circuits de mesure de courant et l'un des deux circuits de mesure de tension obtenus en ouvrant les interrupteurs 118, 119. Dans ce cas, les sous-cellules 120 sont illuminées simultanément pour réaliser les mesures des caractéristiques I-V de ces sous-cellules 120.

En variante, il est possible que les mesures des caractéristiques I-V des sous-cellules 120 soient réalisées successivement en utilisant par exemple un seul dispositif de mesure 110 qui est alors relié successivement aux circuits de mesure associés à chacune des sous-cellules 120. Dans ce cas, les sous-cellules 120 peuvent être illuminées successivement pour réaliser les mesures des caractéristiques I-V des sous-cellules 120, les résultats de mesure pouvant être multiplexés temporellement en sortie du dispositif de mesure 110. Il est également possible que les mesures des caractéristiques I-V des sous-cellules 120 soient réalisées au cours d'une même illumination des sous-cellules 120.

Les caractéristiques I-V des sous-cellules 120 mesurées correspondent à des courbes représentant chacune le courant délivré par l'une des sous-cellules 120 en fonction de la valeur de la tension aux bornes de cette sous-cellule 120.

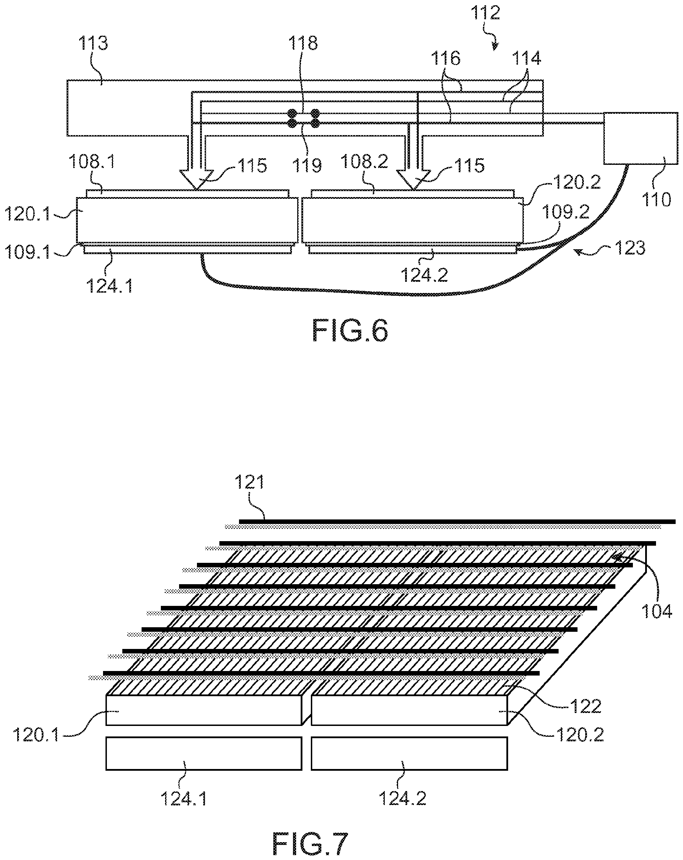

Lors d'une quatrième étape 40, les sous-cellules 120 sont reliées électriquement entre elles en parallèle pour former un ensemble 123 dont la caractéristique I-V est mesurée. Ces liaisons électriques parallèles entre les sous-cellules 120 sont ici réalisées en fermant les interrupteurs 118, 119 et en reliant électriquement entre elles les parties 124.1, 124.2 scindées de l'élément de contact 124 utilisé pour contacter les métallisations 109.1, 109.2 présentes en face arrière des sous-cellules 120. La figure 6 représente schématiquement la configuration obtenue lors de cette étape.

Lorsque les sous-cellules 120 ont été préalablement réassemblées pour reconstituer un ensemble ayant physiquement la même géométrie que celle de la cellule 102, les troisième et quatrième étapes 30 et 40 peuvent être mises en oeuvre successivement, sans interruption.

En variante, avec le multiplexage temporel, les étapes 30 et 40 peuvent être mises en oeuvre avec une seule et même illumination des sous-cellules 120 et avec un même dispositif de mesure 110. Dans ce cas, sous la même illumination, la caractéristique I-V de chacune des sous-cellules 120 est mesurée individuellement (étape 30), le dispositif de mesure 110 étant relié alternativement à chacun des circuits de mesure courant - tension des sous-cellules 120. Les interrupteurs 118 et 119 sont ensuite fermés pour mettre en oeuvre l'étape 40.

La mesure de la caractéristique I-V de l'ensemble 123 formé en reliant électriquement en parallèle les sous-cellules 120 est mise en oeuvre dans les mêmes conditions d'illumination et de mesure que celles avec lesquelles la précédente mesure de la caractéristique I-V de la cellule 102 non découpée (étape 10) et des précédentes mesures des caractéristiques I-V des sous-cellules 120 (étape 30) sont mises en oeuvre.

Au cours d'une étape 50, l'impact de la découpe sur les performances électriques de la cellule 102 est quantifié.

Pour quantifier l'impact de la découpe sur les performances électriques de la cellule 102, des paramètres de performance de la cellule photovoltaïque 102 non découpée, de chacune des sous-cellules 120 et de l'ensemble 123 comprenant toutes les sous-cellules 120 reliées électriquement entre elles en parallèle sont déterminés à partir des caractéristiques I-V précédemment mesurées. Pour chacune de ces caractéristiques I-V, un ou plusieurs des paramètres suivants sont par exemple déterminés ou calculés : le courant de court-circuit $I_{SC}$ ou la densité de courant de court-circuit $J_{SC}$, la tension en circuit ouvert Voc, le facteur de forme FF, le courant Imax et la tension Vmax permettant d'obtenir la puissance maximale Pmax délivrée par la cellule 102, le rendement de conversion $\eta$.

Ces paramètres sont définis par l'équation suivante :

$$\eta = \frac{P_{max}}{P_L} = \frac{V_{max} \cdot I_{max}}{P_L} = \frac{FF \cdot I_{SC} \cdot V_{OC}}{P_L}$$

avec $P_L$ correspondant à la puissance lumineuse reçue, par exemple 1000W/m² dans les conditions standards.

Les paramètres Isc, $V_{OC}$, $V_{max}$ et $I_{max}$ peuvent être déterminés directement à partir des courbes des caractéristiques I-V.

En outre, la densité de courant de court-circuit Jsc correspond au courant de court-circuit $I_{SC}$ normalisé par la surface de la cellule 102, ou de l'une des sous-cellules 120 ou de l'ensemble 123 formé des sous-cellules 120 reliées en parallèle.

La disparité additionnelle, crée par l'étape de découpe de la cellule 102, est ensuite quantifiée en calculant, pour chacune des sous-cellules 120, la différence entre la valeur d'au moins un paramètre de performance électrique de la sous-cellule 120 et la valeur d'au moins un paramètre de performance électrique de la cellule photovoltaïque 102 non découpée de même nature que celui considéré pour la sous-cellule photovoltaïque. Pour chaque sous-cellule 120, les valeurs d'un ou plusieurs paramètres de performances sont donc comparées par rapport à celle de ce ou ces mêmes paramètres déterminés pour la cellule entière 102. Pour les paramètres qui dépendent de la surface considérée ($I_{SC}$, $I_{max}$, $P_{max}$), ce sont les valeurs normalisées par la taille de la cellule qui sont comparées.

Les pertes à la découpe sont également quantifiées en calculant la différence entre la valeur d'au moins un paramètre de performance électrique de l'ensemble 123 comprenant toutes les sous-cellules photovoltaïques reliées électriquement entre elles en parallèle et la valeur d'au moins un paramètre de performance électrique de la cellule photovoltaïque 102 non découpée de même nature que celui considéré pour ledit ensemble 123.

Le ou les paramètres utilisés pour déterminer la disparité additionnelle sont similaires ou non à ceux utilisés pour évaluer les pertes liées à la découpe de la cellule 102. De manière avantageuse, la disparité additionnelle et les pertes liées à la découpe sont calculées à partir de la valeur de la tension de circuit ouvert Voc déterminée pour chacune des caractéristiques I-V précédemment mesurées.

Pour la mise en oeuvre du procédé décrit ci-dessus, le type d'éléments de contact 112 utilisés dépend des métallisations présentes en face avant et arrière de la cellule 102 : peignes munis de pointes de contact lorsque les métallisations correspondent à des bus barres, contact pleine plaque (également appelé « chuck ») par exemple en cuivre ou carte d'acquisition PCB pour une métallisation formée d'un seul contact présent en face arrière de la cellule, fils électriquement conducteurs lorsque les métallisations correspondent à des doigts de collecte seuls (sans bus barres), etc.

La figure 7 représente une configuration dans laquelle les métallisations présentes sur la face avant 104 de la cellule 102, et donc également sur les faces avant des sous-cellules 120, correspondent à des doigts de collecte 122 non recouverts par des bus barres. Les éléments de contact correspondent à des fils 121 de matériau électriquement conducteur disposés sur la face avant 104, perpendiculairement aux doigts de collecte 122, et des cartes d'acquisition 124.1, 124.2 de type circuit imprimé (PCB) utilisés en face arrière. Les fils 121 utilisés pour les mesures de courant sont distincts de ceux utilisés pour les mesures de tension. De plus, après la découpe de la cellule 102, plusieurs groupes de fils 121 sont définis tels que chaque groupe de fils soit dédié aux mesures réalisées sur une des sous-cellules 120.

Le procédé de caractérisation électrique décrit précédemment est avantageusement mis en oeuvre sur une ligne de production de modules photovoltaïques utilisant des sous-cellules photovoltaïques. Il est ainsi possible de surveiller la régularité de l'impact de la découpe des cellules sur les performances des sous-cellules obtenues, en suivant l'évolution de la disparité additionnelle apportée par la découpe de la cellule en plusieurs sous-cellules, et en suivant l'évolution des pertes engendrées par l'étape de découpe.

## Revendications

1. Procédé de caractérisation électrique d'au moins une cellule photovoltaïque (102) découpée, comportant :

    a) mesure de la caractéristique I-V de la cellule photovoltaïque (102) non découpée ;
    b) découpe de la cellule photovoltaïque (102) en plusieurs sous-cellules photovoltaïques (120) ;
    c) mesure de la caractéristique I-V de chacune des sous-cellules photovoltaïques (120) non reliées électriquement aux autres sous-cellules photovoltaïques (120) ;
    d) mesure de la caractéristique I-V d'un ensemble (123) comprenant toutes les sous-cellules photovoltaïques (120) reliées électriquement entre elles en parallèle ;
    e) détermination, à partir des caractéristiques I-V mesurées, d'au moins un paramètre de performance électrique de la cellule photovoltaïque (102) non découpée, d'au moins un paramètre de performance électrique de chacune des sous-cellules photovoltaïques (120) et d'au moins un paramètre de performance électrique de l'ensemble (123) comprenant toutes les sous-cellules photovoltaïques (120) reliées électriquement entre elles en parallèle ;
    f) calcul, pour chacune des sous-cellules photovoltaïques (120), de la différence entre la valeur du paramètre de performance électrique de la sous-cellule photovoltaïque (120) et la valeur du paramètre de performance électrique de la cellule photovoltaïque (102) non découpée ;
    g) calcul de la différence entre la valeur du paramètre de performance électrique de l'ensemble (123) comprenant toutes les sous-cellules photovoltaïques (120) reliées électriquement entre elles en parallèle et la valeur du paramètre de performance électrique de la cellule photovoltaïque (102) non découpée.

2. Procédé selon la revendication 1, dans lequel les paramètres de performance électrique utilisés pour le calcul de l'étape f) sont de même nature que ceux utilisés pour le calcul de l'étape g).

3. Procédé selon l'une des revendications précédentes, dans lequel les paramètres de performance électrique utilisés pour les calculs des étapes f) et g) correspondent à des tensions de circuit ouvert.

4. Procédé selon l'une des revendications précédentes, dans lequel les étapes a), c) et d) sont mises en oeuvre avec au moins :

    - un dispositif (110) de mesure de tension et de courant ;
    - des éléments de contact (112, 121, 124) disposés contre des métallisations (108, 109, 122) présentes au niveau des faces avant (104) et arrière (106) de la cellule photovoltaïque (102), chacun des éléments de contact (112, 121, 124) comportant plusieurs parties isolées électriquement les unes des autres et configurées pour être chacune reliée au dispositif (110) de mesure de tension et de courant.

**5.** Procédé selon la revendication 4, dans lequel, lors des étapes a) et d), des interrupteurs (118, 119) sont configurés pour relier électriquement, pour au moins un des éléments de contact (112), les parties dudit élément de contact (112), et lors de l'étape c), les interrupteurs (118, 119) sont configurés pour isoler électriquement les parties dudit élément de contact (112).

**6.** Procédé selon la revendication 5, dans lequel les interrupteurs (118, 119) correspondent à des transistors de puissance et/ou sont disposés au sein des éléments de contact (112).

**7.** Procédé selon l'une des revendications 4 à 6, dans lequel les éléments de contact (112) comportent des peignes (113) chacun muni de plusieurs groupes de pointes (115) avec, dans chaque groupe des pointes (115), des pointes (115) destinées à une mesure de tension et des pointes (115) destinées à une mesure de courant, et dans lequel chaque partie d'un des éléments de contact (112) comprend au moins un des groupes de pointes (115).

**8.** Procédé selon la revendication 7, dans lequel, lors des étapes a), c) et d), les pointes (115) des peignes (113) sont mises en contact avec des métallisations (108) de type bus barres présentes au niveau de la face avant (104) et/ou de la face arrière (106) de la cellule photovoltaïque (102).

**9.** Procédé selon l'une des revendications 4 à 8, dans lequel les éléments de contact comportent des fils (121) qui sont mis en contact avec les métallisations (122) présentes au moins au niveau de la face avant (104) de la cellule photovoltaïque (102).

**10.** Procédé selon l'une des revendications 4 à 9, dans lequel les éléments de contact comportent en outre au moins un élément électriquement conducteur (124) mis en contact avec au moins une métallisation (109) présente sur une face arrière (106) de la cellule photovoltaïque (102), l'élément électriquement conducteur comportant, lors de l'étape c), plusieurs parties (124.1, 124.2) isolées électriquement les unes des autres.

**11.** Procédé selon l'une des revendications précédentes, dans lequel les étapes a), c) et d) sont mises en oeuvre en illuminant la cellule photovoltaïque (102) avec un même spectre lumineux, avec une même puissance lumineuse et à une même température.

**12.** Procédé selon l'une des revendications précédentes, dans lequel l'étape b) comporte la mise en oeuvre d'une découpe laser et/ou d'un clivage mécanique et/ou d'une découpe avec une scie ou un fil diamanté et/ou d'une découpe par jet d'eau.

**13.** Procédé selon l'une des revendications précédentes, dans lequel, lors de l'étape c), les caractéristiques I-V des sous-cellules photovoltaïques (120) sont mesurées simultanément.

**14.** Procédé selon l'une des revendications 1 à 12, dans lequel, lors de l'étape c), les caractéristiques I-V des sous-cellules photovoltaïques (120) sont mesurées successivement par un même dispositif (110) de mesure de tension et de courant, les résultats de mesure étant multiplexés temporellement en sortie du dispositif (110) de mesure.

**Patentansprüche**

**1.** Verfahren zur elektrischen Charakterisierung von mindestens einer zugeschnittenen Photovoltaikzelle (102), beinhaltend:

    a) Messung der I-U-Charakteristik der nicht zugeschnittenen Photovoltaikzelle (102);
    b) Zuschneidung der Photovoltaikzelle (102) in mehrere Photovoltaik-Unterzellen (120);
    c) Messung der I-U-Charakteristik jeder der Photovoltaik-Unterzellen (120), die nicht elektrisch mit den anderen Photovoltaik-Unterzellen (120) verbunden sind;
    d) Messung der I-U-Charakteristik einer Anordnung (123), die alle Photovoltaik-Unterzellen (120) umfasst, die parallel zueinander elektrisch verbunden sind;
    e) Bestimmung, ausgehend von den gemessenen I-U-Charakteristiken, von mindestens einem elektrischen Leistungsparameter der nicht zugeschnittenen Photovoltaikzelle (102), von mindestens einem elektrischen Leistungsparameter jeder der Photovoltaik-Unterzellen (120) und von mindestens einem elektrischen Leistungsparameter der Anordnung (123), die alle Photovoltaik-Unterzellen (120) umfasst, die parallel zueinander elektrisch verbunden sind;
    f) Berechnung, für jede der Photovoltaik-Unterzellen (120), der Differenz zwischen dem Wert des elektrischen Leistungsparameters der Photovoltaik-Unterzelle (120) und dem Wert des elektrischen Leistungsparameters der nicht zugeschnittenen Photovoltaikzelle (102);

g) Berechnung der Differenz zwischen dem Wert des elektrischen Leistungsparameters der Anordnung (123), die alle Photovoltaik-Unterzellen (120) umfasst, die parallel zueinander elektrisch verbunden sind, und dem Wert des elektrischen Leistungsparameters der nicht zugeschnittenen Photovoltaikzelle (102).

2. Verfahren nach Anspruch 1, wobei die für die Berechnung von Schritt f) verwendeten elektrischen Leistungsparameter derselben Art sind wie die für die Berechnung von Schritt g) verwendeten.

3. Verfahren nach einem der vorhergehenden Ansprüche, wobei die elektrischen Leistungsparameter, die für die Berechnungen der Schritte f) und g) verwendet werden, Leerlaufspannungen entsprechen.

4. Verfahren nach einem der vorhergehenden Ansprüche, wobei die Schritte a), c) und d) mindestens ausgeführt werden mit:

- einer Spannungs- und Strommessvorrichtung (110);
- Kontaktelementen (112, 121, 124), die gegen Metallisierungen (108, 109, 122) angeordnet sind, die im Bereich der Vorder- (104) und Rückseite (106) der Photovoltaikzelle (102) vorhanden sind, wobei jedes der Kontaktelemente (112, 121, 124) mehrere elektrisch voneinander isolierte Teile beinhaltet und konfiguriert ist, um jeweils mit der Spannungs- und Strommessvorrichtung (110) verbunden zu werden.

5. Verfahren nach Anspruch 4, wobei in den Schritten a) und d) Schalter (118, 119) konfiguriert werden, um für mindestens eines der Kontaktelemente (112) die Teile des Kontaktelements (112) elektrisch zu verbinden, und in Schritt c) die Schalter (118, 119) konfiguriert sind, um die Teile des Kontaktelements (112) elektrisch zu isolieren.

6. Verfahren nach Anspruch 5, wobei die Schalter (118, 119) Leistungstransistoren entsprechen und/oder innerhalb der Kontaktelemente (112) angeordnet sind.

7. Verfahren nach einem der Ansprüche 4 bis 6, wobei die Kontaktelemente (112) Kämme (113) beinhalten, die jeweils mit mehreren Spitzengruppen (115) mit, in jeder Gruppe der Spitzen (115), Spitzen (115), die für eine Messung der Spannung und der Spitzen (115) bestimmt sind, die für eine Strommessung bestimmt sind, und wobei jeder Teil eines der Kontaktelemente (112) mindestens eine der Spitzengruppen (115) umfasst.

8. Verfahren nach Anspruch 7, wobei in den Schritten a), c) und d) die Spitzen (115) der Kämme (113) mit Metallisierungen (108) vom Typ Busschiene in Kontakt gebracht werden, die an der Vorderseite (104) und/oder der Rückseite (106) der Photovoltaikzelle (102) vorhanden sind.

9. Verfahren nach einem der Ansprüche 4 bis 8, wobei die Kontaktelemente Drähte (121) beinhalten, die mit den mindestens an der Vorderseite (104) der Photovoltaikzelle (102) vorhandenen Metallisierungen (122) in Kontakt gebracht werden.

10. Verfahren nach einem der Ansprüche 4 bis 9, wobei die Kontaktelemente ferner mindestens ein elektrisch leitfähiges Element (124) beinhalten, das mit mindestens einer Metallisierung (109), die auf einer Rückseite (106) der Photovoltaikzelle (102) vorhanden ist, in Kontakt gebracht wird, wobei das elektrisch leitfähige Element in Schritt c) mehrere elektrisch voneinander isolierte Teile (124.1, 124.2) beinhaltet.

11. Verfahren nach einem der vorhergehenden Ansprüche, wobei die Schritte a), c) und d) ausgeführt werden, indem die Photovoltaikzelle (102) mit demselben Lichtspektrum, mit derselben Lichtleistung und bei derselben Temperatur beleuchtet wird.

12. Verfahren nach einem der vorhergehenden Ansprüche, wobei der Schritt b) die Ausführung eines Laserschneidens beinhaltet und/oder eines mechanischen Spaltens und/oder einer Zuschneidung mit einer Säge oder einem Diamantdraht und/oder eines Wasserstrahlschneidens.

13. Verfahren nach einem der vorhergehenden Ansprüche, wobei in Schritt c) die I-U-Charakteristiken der Photovoltaik-Unterzellen (120) gleichzeitig gemessen werden.

14. Verfahren nach einem der Ansprüche 1 bis 12, wobei in Schritt c) die I-U-Charakteristiken der Photovoltaik-Unterzellen (120) nacheinander durch eine selbe Spannungs- und Strommessvorrichtung (110) gemessen werden, wobei die Messergebnisse am Ausgang der Messvorrichtung (110) zeitmultiplexiert werden.

**Claims**

1. A method for electrically characterising at least one cut photovoltaic cell (102), including:

a) measuring the I-V characteristic of an uncut photovoltaic cell (102);

b) cutting the photovoltaic cell (102) into several photovoltaic sub-cells (120);

c) measuring the I-V characteristic of each of the photovoltaic sub-cells (120) not electrically connected to the other photovoltaic sub-cells (120);

d) measuring the I-V characteristic of an assembly (123) comprising all the photovoltaic sub-cells (120) electrically connected to each other in parallel;

e) determining, from the I-V characteristics measured, at least one electric performance parameter of the uncut photovoltaic cell (102), at least one electric performance parameter of each of the photovoltaic sub-cells (120) and at least one electric performance parameter of the assembly (123) comprising all the photovoltaic sub-cells (120) electrically connected to each other in parallel;

f) calculating, for each of the photovoltaic sub-cells (120), the difference between the value of the electric performance parameter of the photovoltaic sub-cell (120) and the value of the electric performance parameter of the uncut photovoltaic cell (102);

g) calculating the difference between the value of the electric performance parameter of the assembly (123) comprising all the photovoltaic sub-cells (120) electrically connected to each other in parallel and the value of the electric performance parameter of the uncut photovoltaic cell (102).

2. The method according to claim 1, wherein the electric performance parameters used for calculating in step f) are of the same nature as those used for calculating in step g).

3. The method according to one of the preceding claims, wherein the electric performance parameters used for calculating in steps f) and g) correspond to open circuit voltages.

4. The method according to one of the preceding claims, wherein steps a), c) and d) are implemented with at least:

- a voltage and current measurement device (110) ;
- contact elements (112, 121, 124) disposed against metallizations (108, 109, 122) present at the front (104) and rear (106) faces of the photovoltaic cell (102), each of the contact elements (112, 121, 124) including several parts electrically insulated from each other and configured to be each connected to the voltage and current measurement device (110).

5. The method according to claim 4, wherein during steps a) and d), switches (118, 119) are configured to electrically connect, for at least one of the contact elements (112), the parts of said contact element (112), and during step c), the switches (118, 119) are configured to electrically insulate the parts of said contact element (112).

6. The method according to claim 5, wherein the switches (118, 119) correspond to power transistors and/or are disposed within the contact elements (112).

7. The method according to one of claims 4 to 6, wherein the contact elements (112) include combs (113) each provided with several groups of tips (115) with, in each group of the tips (115), tips (115) for measuring voltage and tips (115) for measuring current, and wherein each part of one of the contact elements (112) comprises at least one of the groups of tips (115).

8. The method according to claim 7, wherein during steps a), c) and d), the tips (115) of the combs (113) are contacted with busbar-type metallizations (108) present at the front face (104) and/or the rear face (106) of the photovoltaic cell (102).

9. The method according to one of claims 4 to 8, wherein the contact elements include wires (121) which are contacted with the metallizations (122) present at least at the front face (104) of the photovoltaic cell (102).

10. The method according to one of claims 4 to 9, wherein the contact elements further include at least one electrically conductive element (124) which is contacted with at least one metallization (109) present on a rear face (106) of the photovoltaic cell (102), the electrically conductive element including, during step c), several parts (124.1, 124.2) electrically insulated from each other.

11. The method according to one of the preceding claims, wherein steps a), c) and d) are implemented by illuminating the photovoltaic cell (102) with a same light spectrum, with a same light power and at a same temperature.

12. The method according to one of the preceding claims, wherein step b) includes implementing laser cutting and/or mechanical cleaving and/or cutting with a saw or diamond wire and/or water jet cutting.

13. The method according to one of the preceding claims, wherein during step c), the I-V characteristics of the photovoltaic sub-cells (120) are measured simultaneously.

14. The method according to one of claims 1 to 12, wherein during step c), the I-V characteristics of the photovoltaic sub-cells (120) are measured successively by a same voltage and current measurement device (110), the measurement results being time multiplexed at the output of the measurement device (110).

MESURE I-V SUR CELLULE NON DECOUPEE — 10

DECOUPE DE LA CELLULE EN PLUSIEURS SOUS-CELLULES — 20

MESURE I-V SUR CHACUNE DES SOUS-CELLULES DECOUPEES — 30

MESURE I-V SUR LA CELLULE FORMEE PAR LES SOUS-CELLULES — 40

QUANTIFIER L'IMPACT DE LA DECOUPE SUR LES PERFORMANCES ELECTRIQUES DE LA CELLULE — 50

FIG.1

FIG.2

FIG.3

FIG.4

FIG.5

FIG.6

FIG.7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• WO 2013179898 A